# EUROPEAN PATENT SPECIFICATION

(11) **EP 0 916 181 B1**
(45) Date of publication and mention of the grant of the patent: **01.10.2003**
(21) Application number: 97933452.1
(22) Date of filing: 15.07.1997
(51) Int. Cl.: H03B 1/00, G05F 1/56

(54) **VOLTAGE TO CURRENT CONVERTER FOR HIGH FREQUENCY APPLICATIONS**
SPANNUNG-STROM-UMSETZER FÜR HOCHFREQUENTE ANWENDUNGEN
CONVERTISSEUR TENSION-COURANT POUR APPLICATIONS A HAUTE FREQUENCE

(30) Priority: 02.08.1996 US 691562
(43) Date of publication of application: 19.05.1999
(73) Proprietor: ATMEL CORPORATION, San Jose, California 95131 (US)
(72) Inventor: RIVOIR, Roberto, I-70124 Bari (IT); MALOBERTI, Franco, I-27020 Torre d'Isola (IT)
(74) Representative: Käck, Jürgen
(86) International application number: PCT/US97/12267
(87) International publication number: WO 98/006169

(56) References cited:
- US-A- 4 703 249
- US-A- 5 357 156
- US-A- 5 519 310
- US-A- 5 606 277
- DESIGNER'S CASEBOOK, May 1979, SHIH KEVIN, "Voltage-to-Current Converter Handles Bilateral Signals", page 124.
- INSPEC., September 1975, OLESIN ANDREW, "Bilateral Current Source is Digitally Programable", pages 95 and 97.

## Description

### Technical Field

The invention relates to integrated voltage-to-current converters of the type used in switch-current integrated circuits.

### Background Art

A voltage-to-current converter (VI), also commonly called a transconductance amplifier, is an analog circuit performing an analog conversion of an input voltage signal into an analog output current signal.

The reverse function of the VI is performed by the current-to-voltage converter (IV), or transresistance amplifier. In the past, a far greater effort of research and design has been devoted to the IV than to the VI. This is because most circuits function within the voltage domain. That is, most of the "external analog word" represents signals in voltages. Therefore, there have traditionally been far more applications for IV conversions than for VI conversions.

Recently, the need for high frequency analog integrated circuits has resulted in the development of a new analog design technique called current-mode, or switched-current (SI), technology. Current-mode techniques allow the implementation of high-performance analog circuits using digital CMOS processes. Current-mode ICs achieve higher frequency performance than voltage mode ICs because information is transmitted merely by steering current one way or another. Therefore, these circuits do not suffer from long rise/fall and settling times caused by capacitive loading associated with voltage mode ICs.

To explain the importance of VI conversion as a fundamental block in current-mode circuits, one may consider for example an analog-to-digital converter ("ADC") in the video range having a sampling operating frequency range from the low kilohertz up to 20-54 Msps or more.

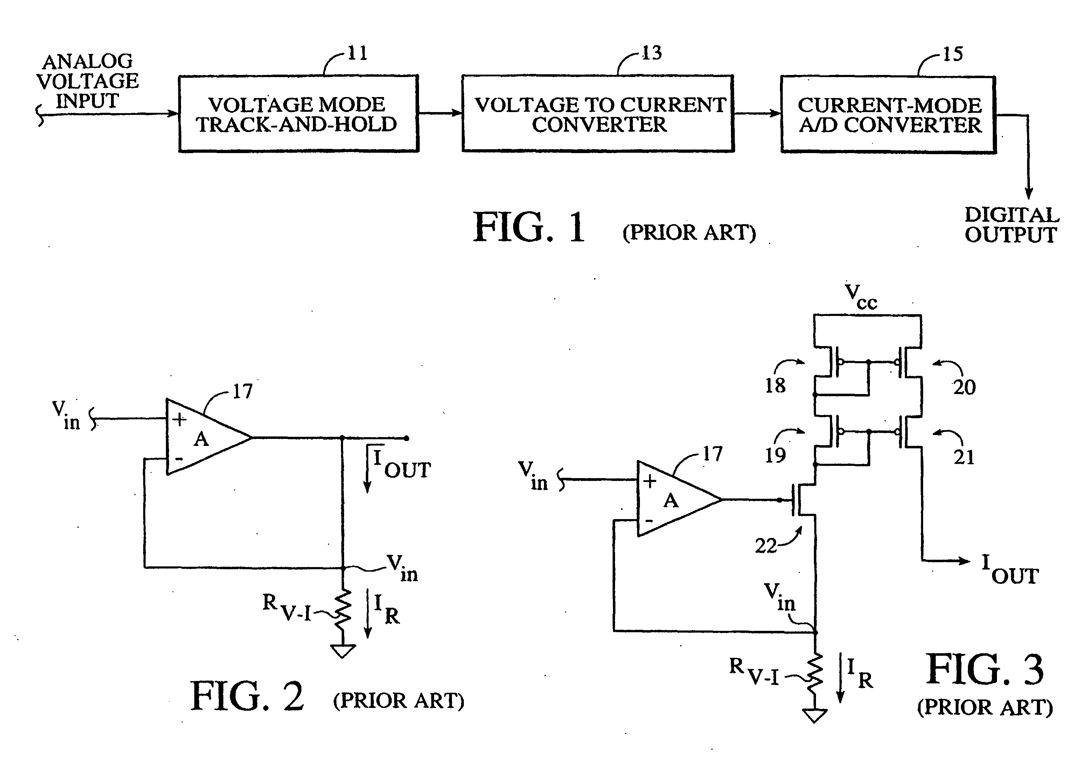

With reference to Fig. 1, a current-mode implementation of an ADC needs at least a track-and-hold 11, a voltage-to-current converter 13 and a current-mode ADC. An analog voltage input signal is first applied to the tracked-and-hold 11 in the voltage domain where it is sampled. The sampled voltage is then converted to a current signal by the VI converter 13 and delivered to a current mode ADC. The track-and-hold 11 and VI 13 may be interchanged. Thus a wide frequency analog voltage input may be applied directly to the VI 13 and immediately converted to current. Therefore, a need exists for wide frequency VI converters.

There are not many examples of voltage-to-current converters in literature, especially for digital CMOS technology. A basic VI converter based on a differential amplifier 17 is shown in Fig. 2. In a good differential amplifier, Diff Amp, 17 the voltage drop across the positive and negative input terminals and the current into the input terminals are both practically zero. Since the voltage drop across the input terminals of Diff Amp 17 is practically zero, an input signal Vᵢₙ applied to the positive input terminal also appears at the negative input terminal and is thereby applied across a voltage-to-current resistor R_{V-I}. A current I_{R} of magnitude V_{IN}/R_{V-I} develops through resistor R_{V-I}. Since hardly any current flows into or out of the positive and negative input terminals of Diff Amp 17, the current I_{R} is very similar to the output current I_{OUT} supplied to a load, not shown. The output current I_{OUT} is therefore practically equal to I_{R}, the current through resistor R_{V-I}.

However, since the Op Amp 17 is arranged as a voltage follower, the voltage series feedback tends to decrease the output impedance such that the output impedance is equal to R_{V-I}. Since the value of an integrated resistor is susceptible to process variations, the gain of the circuit cannot be accurately predicted. Moreover, the gain is also susceptible to temperature variations due to the temperature coefficient of an integrated resistor. As a result, the resistor R_{V-I} would have to be placed external to an IC chip and the circuit could not be fully integrated.

A transistor level VI converter incorporating a Diff Amp 17 as in Fig. 2, but offering improved output impedance, is shown in Fig. 3. The VI converter of Fig. 3 incorporates the teachings of Hadri et al. in "Impedance Boosting Techniques Based on BiCMOS Technology", IEEE Journal of Solid State Circuits, Vol. 28, No. 2, Feb. 1993, pp. 157-161 and the teachings of Bult et al. in "A Fast-Setting CMOS Op Amp for SC Circuits with 90-db DC Gain", IEEE Journal of Solid State Circuits, Vol. 25, No. 6, Dec. 1990, pp. 1379-1381. Fig. 3 shows Diff Amp 17 and resistor R_{V-I} of Fig. 2, but the output of Diff Amp 17 drives the input of an nMOS transistor 22. This configuration behaves like a "boosted" cascode amplifier and has an output impedance of R_{V-I} + rds₂₂ + (A+1)gm₂₂rds₂₂R_{V-I} , where A is the open loop gain of Op Amp 17, and gm₂₂ and rds₂₂ are the small-signal transconductance gain and output resistance of transistor 22. To properly isolate the signal current I_{R} generated in nMOS transistor 22 and resistor R_{V-I}, the signal current I_{R} must be mirrored to produce an output current I_{OUT} to a load. A pMOS cascode current mirror consisting of pMOS transistor 18-21 is used to perform this task.

The increased output impedance of the voltage-to-current converter of Fig. 3, however, comes at the expense of increased power consumption and reduced linearity. A voltage-to-current converter typically interprets a positive analog voltage signal as a bipolar voltage signal about a reference ground, V_{ref} = V_{cc}/2, and converts the bipolar voltage signal into a unipolar current. As a result, the bias current through R_{V-I} resulting from the reference ground would by V_{ref}/R_{V-I}, and this value can be substantially high to achieve a satisfactory performance. For example, for a transconductance gain of 0.5 mA/v and a V_{ref} of 2.5 V, R_{V-I} would be about 2 KΩ, resulting in a bias current of 2.5V / 2KΩ = 1.25 mA through the nMOS 22/R_{V-I} branch alone.

The second, and more severe limitation is due to the signal I_{R} having to be mirrored in order to produce the output current I_{OUT}. This task is performed by the pMOS cascode current mirror 18-21, but current mirrors, in general, suffer from high non-linearities which must be reduced either by introducing feedback or by increasing their bias current. The architecture of Fig. 3 requires that the cascode current mirror 18-21 remain outside of the feedback loop. As a result, its non-linearities must be reduced by increasing its bias current. The resultant bias current in the combination of the cascode current mirror 18-21 and the nMOS 22/R_{V-I} branch necessary for achieving sufficient linearity levels would be unsatisfactorily high.

Finally, the necessary current mirror 18-21 also has the adverse effect of reducing the overall output impedance of the voltage-to-current converter.

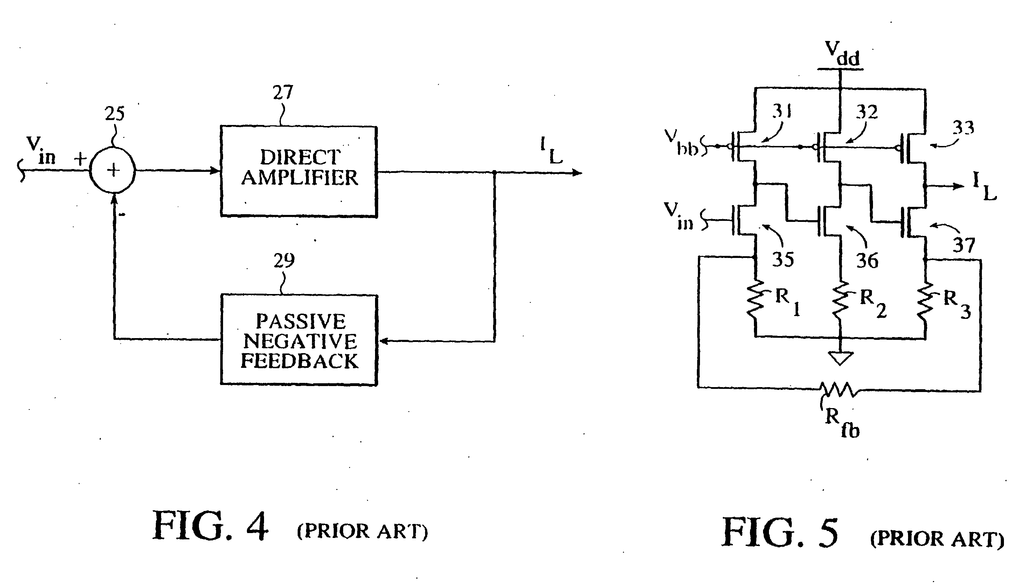

A more common and suitable circuit topology follows the diagram of Fig. 4 which avoids having any active devices process an output current I_{L} outside of the feedback loop, and hence exhibits higher linearity levels. Vᵢₙ is shown to enter a summation node 25 feeding into a direct amplifier 27 having a passive negative feedback network 29. The passive negative feedback network 29, which consists of a resistive network, eliminates any non-linearities introduced by the use of active devices, such as transistors, in the feedback path. The gain of the feedback network 29 is therefore established by a resistive network rather than by the size of an individual resistor, resulting in a reduced susceptibility to process variations.

Fig. 5 is an example of a typical circuit following the diagram of Fig. 4. Here, a three stage direct amplifier with overall passive negative feedback is shown. Since AC coupling between gain stages is practically prohibitive in integrated circuits due to excessive real estate requirements, DC and AC signal components cannot be separated in the biasing and optimizing of the circuit. Use of overall feedback results in a higher degree of bias stability and desensitization of individual gain tolerances.

Each amplifier stage consists of a PMOS transistor, 31-33, respectively used as a current source controlled by a bias voltage V_{bb}, a non-linear gain element respectively provided by transistors 35-37 and a degenerative feedback resistors R₁-R₃, respectively. The first stage consists of transistors 31 and 35 and resistor R₁ connected sequentially and forming an inverting amplifier between V_{dd} and ground. Input signal Vᵢₙ is applied to NMOS transistor 35. R₁ forms resistive degenerative feedback which increases the frequency response of the first stage. The output from the first stage is taken at the drain of transistor 35 and applied to the second stage which consists of transistors 32 and 36 and resistor R₂. The second stage functions in much the same way as the first stage and couples its output from the drain of transistor 36 to the third stage which consists of transistors 33 and 37 and resistor R₃.

The passive negative feedback network of Fig. 5 consists of resistors R₁, R₃ and R_{fb}. Resistive network R₁, R₃ and R_{fb} respond to a proportional measure of the output current I_{L} sensed at the source of transistor 37, convert it into a voltage which includes both AC and DC components, and feed the voltage back to the input at the source of transistor 35, which acts as a summation node. The feedback voltage is thereby dependent on a relationship of the feedback resistors R₁, R₃ and R_{fb}.

However, this circuit topology also presents some disadvantages. In order to obtain sufficient gain, a three gain stage network is necessary, which results in three poles and thus a reduced frequency response and reduced linearity. Due to large tolerances in integrated resistors and MOS transistors, especially in low-cost CMOS digital processes, it is quite complicated and unreliable to simultaneously correctly bias the three-stage amplifier. To stabilize the operating point, i.e. the quiescent point, special techniques like common mode feedback are required which tend to complicate the circuit and reduce its performance. Additionally, since the direct amplifier consists of three cascaded inverting amplifying stages, the output signal I_{L} is not in phase with the input signal Vᵢₙ. Furthermore, the feedback gain achievable with the resistive network of R₁, R₃ and R_{fb} may not be sufficient for many applications.

Many applications require that a VI converter have a very fine resolution. That is, a VI should be able to convert a relatively large input voltage step into a very small, but accurate current step. For example, to interface an 8-bit current-mode ADC, a gain of 0.5 mA/V may be needed. For a 10-bit ADC, a resolution of 0.25 mA/V is necessary. To achieve this, the transconductance gain, i.e. voltage-to-current conversion gain, of the direct amplifier, 27 in Fig. 4, must be small enough to reduce an input Vᵢₙ of a few volts to an output I_{L} of a fraction of a milliampere. As a result, the transresistance gain or current-to-voltage gain, of the passive feedback network 29 in Fig. 4 must be very high to convert a measure of the output current, which may be a fraction of a milliampere, into a relatively large feedback voltage to feed into summation node 25. This is especially apparent when one considers that the DC offset and gain accuracy of an ADC must be contained within one least significant bit to avoid offset and gain errors. This means that the precision of the DC characteristics should be on the order of 0.5-1.0 µA for the 8-bit and 0.25-0.50 µA for the 10-bit examples given above.

It can be readily demonstrated that the transresistance gain of the feedback network of Fig. 5 is given by (R₁*R₃)/(R₁+R₃+R_{fb}). This feedback gain is heavily dependent on R1 and R3, which are also an integral part of the direct amplifier. Therefore, any attempt to increase the transresistance gain is physically limited by practical considerations involving the required biasing conditions of the direct amplifier. As a result, this circuit cannot viably achieve sufficient transresistance feedback gain to obtain the fine tuning necessary for many high-performance applications.

An alternative voltage-to-current converter using active feedback is described in US 5,519,310.

It is an object of the present invention to provide a wide frequency voltage-to-current converter with fine tuning capabilities and a self-compensating scheme. It is another object of the present invention to provide a voltage-to-current converter having a high, stable and predictable transresistance feedback gain equal to a ratio of resistor values and does not introduce non-linearities into the feedback path. It is another object of the present invention that the biasing condition of the direct amplifier of the overall voltage-to-current converter be independent of any adjustment to the transresistance feedback gain network. It is another object of the present invention to provide an integrated voltage-to-current converter with stable DC bias conditions and optimized AC performance.

### Summary of the Invention

These objects have been met in an integrated voltage-to-current converter having an overall active negative feedback network consisting of an active, differential current-to-voltage converter having a gain determined only by a resistive ratio.

The voltage-to-current conversion of the direct amplifier of the present invention preferably consists of a two-stage direct transconductance amplifier. The first stage of the two-stage direct transconductance amplifier is a voltage-to-voltage converter, or voltage amplifier, and the second stage of the two-stage direct transconductance amplifier is a voltage-to-current converter, or transconductance amplifier. The two-stage direct transconductance amplifier has an overall active negative feedback network consisting of a differential current-to-voltage converter which translates only the AC component of a measure of an output current into a feedback voltage.

The voltage-to-voltage converter, that is, the first stage of the two-stage direct transconductance amplifier serves to condition an input voltage signal for use by the second stage of the two-stage direct amplifier. The voltage-to-voltage converter preferably has a high degree of linearity over a wide frequency range, a small gain, a high input impedance so as to not load an input voltage signal and a low output impedance so as to not load the second stage of the two-stage direct amplifier. The voltage-to-voltage converter of the present invention preferably has local degenerative feedback in the form of a first pull-down resistor and may also have a pull-up bias resistor or a current source. If a current source is used, then it preferably receives a bias signal from a first bias tree having a structure identical to the structure of the voltage-to-voltage converter itself.

The transconductance amplifier, that is, the second stage of the two-stage direct amplifier, receives a conditioned voltage signal from the voltage-to-voltage converter of the first stage and converts the conditioned voltage signal into a proportional output current signal. The second stage of the two stage direct amplifier preferably has local degenerative feedback by use of a second pull-down resistor. The transconductance amplifier of the second stage preferably has a simple cascode or regulated cascode current source which receives a bias signal from a second bias tree having a structure identical to the transconductance amplifier itself.

The differential current-to-voltage converter forming the overall active negative feedback network of the present invention consists of a closed-loop differential amplifier, or Diff Amp, having local resistive feedback. The Diff Amp of the present invention has a negative input terminal, a positive input terminal and an output terminal. An input resistor is coupled between the negative input terminal of the Diff Amp and the second pull-down resistor forming the local degenerative feedback network of the second stage of the two-stage direct amplifier. In this way the resistor of the second stage, or transconductance amplifier, serves as a current sense element for the differential current-to-voltage converter of the overall active negative feedback. A local feedback resistor is coupled between the output terminal and negative input terminal of the Diff Amp. The positive input terminal of the Diff Amp receives a signal substantially similar to the DC component of the voltage across the pull-down resistor of the second stage, or transconductance, amplifier.

As explained before, the second bias tree providing the control bias signal for the transconductance amplifier has a structure identical to the transconductance amplifier. In essence, the second bias tree is a copy of the transconductance amplifier. The transconductance amplifier receives a conditioned voltage signal having a DC and an AC component and therefore produces an output current having an AC and an DC component, but the second bias tree receives only a DC reference voltage. Since the second bias tree is identical to the transconductance amplifier, it produces a DC signal substantially similar to the DC signal of the transconductance amplifier. The DC signal from the second bias tree is fed into the positive input terminal of the Diff Amp. In essence the second bias tree, which has a resistor equal to the degenerative feedback resistor of the transconductance amplifier, serves as a bias signal generator for the Diff Amp. Since both the positive and negative inputs of the Diff Amp receive substantially the same DC voltage, the Diff Amp rejects the DC component of the output current and responds only to the AC component of the output current. In this manner, only the AC component of the output current is converted into an amplified feedback voltage.

### Brief Description of the Drawings

Fig. 1 is a block diagram of prior art analog-to-digital converter using a voltage-to-current converter.
Fig. 2 is a prior art voltage-to-current converter.
Fig. 3 is a prior art MOS implementation of the voltage-to-current converter shown in Fig. 2
Fig. 4 is block diagram of a prior art voltage-to-current converter.
Fig. 5 is a prior art MOS voltage-to-current converter in accord with Fig. 4.
Fig. 6 is a block diagram of a voltage-to-current converter in accord with the present invention.
Fig. 7 is a block diagram of a voltage-to-current converter in accord with a first embodiment of the present invention.
Fig. 8 is a block diagram of a voltage-to-current converter in accord with a second embodiment of the present invention.
Fig. 9 is a basic MOS implementation of a voltage-to-current converter in accord with the present invention.
Fig. 10 is a more detailed description of the circuit shown in Fig. 9, and showing the use of a simple cascode current source.
Fig. 11 is an alternative variation on the circuit shown in Fig. 10.
Fig. 12 is an alternative variation on the circuit shown in Fig. 9 and showing the use of a regulated cascode current source.
Fig. 13 is a fully dual differential current-to-voltage converter having dual inputs and dual outputs in accord with the present invention.

### Best Mode for Carrying Out the Invention

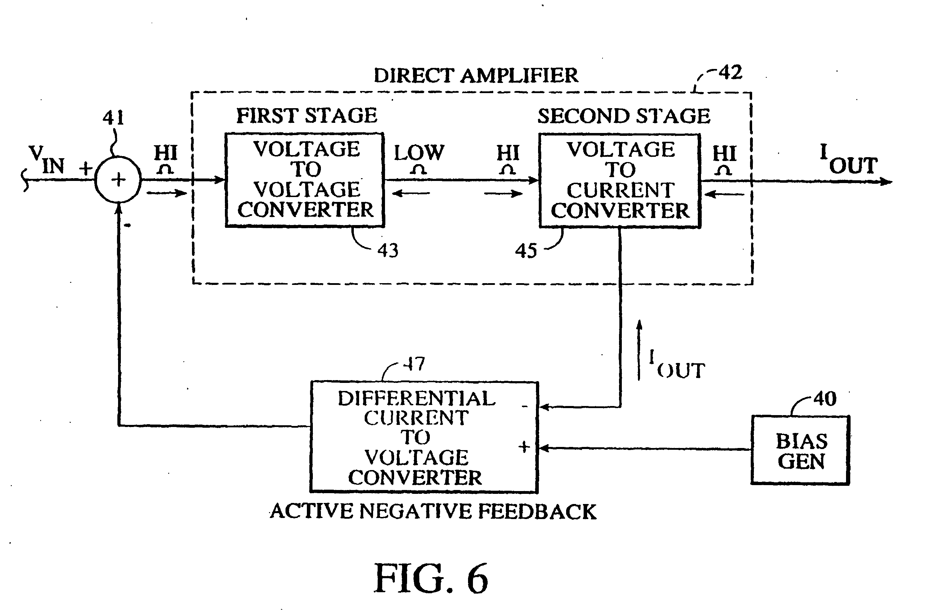

With reference to Fig. 6, a representative view of the present invention is shown. The present invention includes a direct amplifier 42. As is known in the art, a direct amplifier has an input, output and one or more gain stages therebetween, but no feedback from the output to the input. Preferably, the direct amplifier of the present invention has two stages 43 and 45. The first stage 43 is a voltage-to-voltage converter, i.e. voltage amplifier, having a high input impedance and a low output impedance. The first stage 43 feeds into the second stage 45, a voltage-to-current converter, i.e. transconductance amplifier, having a high input impedance and a high output impedance. The second stage voltage-to-current converter 45 outputs a current I_{OUT} which is sensed by an active negative feedback, differential current-to-voltage converter 47 having a gain preferably much larger than unity. The differential current-to-voltage converter 47 also has a second input receiving a bias signal from a bias generator 40. The bias signal from the bias generator 40 is typically a DC voltage signal, but it can be a DC current signal.

Bias generator 40 preferably produces a bias signal equal to a measure, in voltage or current, of the DC component of I_{OUT} such that in the process of rejecting the common mode signal of both its inputs, the differential current-to-voltage converter 47 outputs an amplified AC voltage signal proportional only to the AC component of I_{OUT}. In this manner, the feedback network is less influenced by DC bias, temperature or process drifts. The output from the differential current-to-voltage converter 47 is subtracted from an input signal Vᵢₙ at summation node 41 and thereby forms an overall feedback network encompassing both stages, 43 and 45, of the direct amplifier 42.

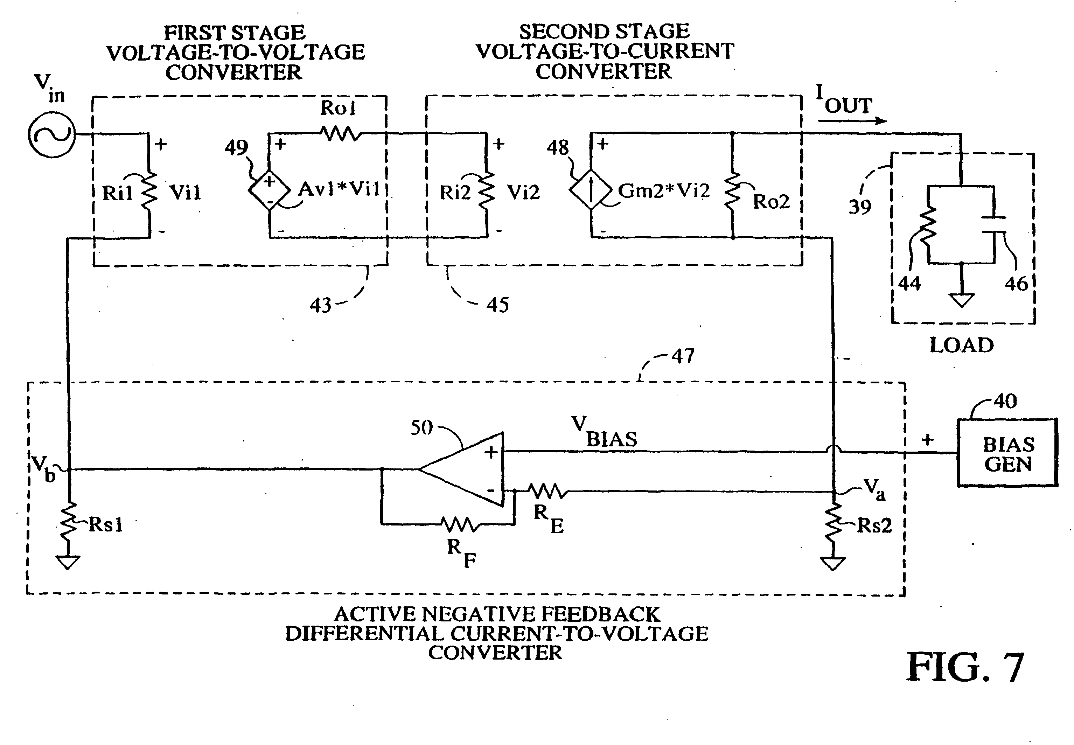

With reference to Fig. 7, an idealized representation of the present invention is shown in circuit form. Again, the two-stage direct amplifier is shown to be composed of a voltage-to-voltage converter, or voltage amplifier, 43 followed by a voltage-to-current converter, or transconductance amplifier 45, with an active, negative feedback consisting of differential current-to-voltage converter network 47. The differential current-to-voltage converter feedback network 47 consists of resistor Rs2, resistor Rs1, and a closed-loop differential amplifier 50 which includes input resistor R_{E} and local feedback resistor R_{F}.

The input signal Vᵢₙ is applied to the voltage amplifier 43 which provides a high input impedance Ri1 to minimize any loading effects on Vᵢₙ and thereby improve the linearity of the overall voltage-to-current converter of Fig. 7. The voltage difference between Vᵢₙ and the voltage across Rs at node Vb forms a voltage drop Vi1 across Ri1 which is reflected by dependent voltage source 49 as an output voltage equal to Vi1 amplified by a transresistance gain, Av1.

The output of dependent voltage source 49 is applied through a low output impedance Ro1 to a high input impedance Ri2 of the transconductance amplifier 45. The voltage drop Vi2 across Ri2 is reflected as a current by voltage dependent current source 48 which has a transconductance gain of Gm2. Voltage dependent current source 48 is connected in parallel with an output impedance Ro2 made to be high to improve the linearity of the overall circuit of Fig. 7. The output current I_{OUT} leaving the transconductance amplifier 45 is applied to a load 39 symbolized by the parallel combination of a resistor 44 and a capacitor 46.

The output current I_{OUT} also flows through Rs2 and is sensed at node Va. Node Va is coupled through R_{E} to the inverting, i.e. negative, input terminal of Diff Amp 50. The output of Diff Amp 50 is fed back through local feedback resistor R_{F} to the same inverting input and thereby forms a local closed-loop negative feedback network. The non-inverting, i.e. positive, input terminal of Diff Amp 50 is coupled to a reference voltage, V_{BIAS}.

As explained above V_{BIAS} is produced by bias generator 40 and is preferably equal to the DC component of the voltage at node Va. In this manner, Diff Amp 50 rejects all common mode and drift voltages while it converts and amplifies only the AC component of the output current I_{OUT}. Thus the DC bias conditions of the direct amplifier may be optimized separate from the AC feedback circuit. This allows for the DC operating point of the VI converter of the present invention to auspiciously be made to match the potential of the load 39 without consideration to any ill effects to the feedback gain. It is further noted that this operating point should be stable as much as possible in temperature and with process variations. More importantly, the gain of the closed-loop Diff Amp 50 may be adjusted without affecting the direct amplifier.

The local closed loop differential amplifier 50 has a constant gain of -R_{F}/R_{E} over a given operating frequency range. Therefore, the sensed voltage at Va is amplified by a gain of -R_{F}/R_{E} and applied across Rs1 at node Vb. The combination of the -R_{F}/R_{E} gain from local closed-loop Diff Amp 50 along with Rs1 and Rs2 form the current-to-voltage active negative feedback network 47. The feedback gain magnitude β of the negative feedback network 47 is Rs2*R_{F}/R_{E}. Assuming that the open-loop gain of the overall voltage-to-current converter, including the two-stage direct amplifier, is much greater than unity, then the overall gain of the entire overall voltage-to-current converter is simply the reciprocal of β, or R_{E}/(R_{F}*Rs2). Since R_{F} and R_{E} are part of only the closed-loop Diff Amp 50, the gain of the active feedback network 47 and the overall voltage-to-current converter can be adjusted without affecting the biasing conditions of the two-stage direct amplifier 43-45.

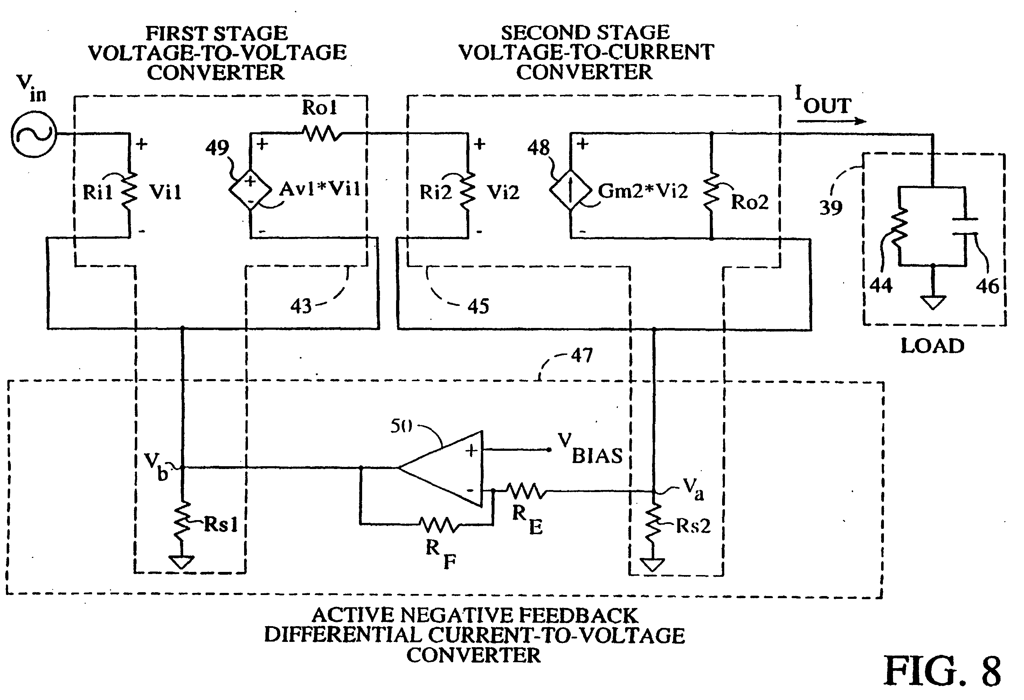

Fig. 8 shows a second representation of a preferred embodiment of the present invention. The configuration of Fig. 8 is substantially the same as the configuration of Fig. 7 and the overall feedback network 47 is the same as in Fig. 7, but the first and second stages, 43 and 45 respectively, of the two-stage direct amplifier are connected to form local, negative degenerative feedback networks. Node Vb is coupled to the reference ground of the output of the first stage 43, the voltage amplifier, such that the output current of stage 43 is sampled through RS1 and fed back as a voltage to the reference ground of the input of the same stage 43. In other words, Rs1 behaves as a degenerative resistor for voltage amplifier 43.

Similarly, node Va is coupled to the reference ground of the input of the second stage 45, the transconductance amplifier, such that the output current I_{OUT} sampled through Rs2 is fed back as a voltage to the reference ground of the input of the second stage 45. Thus Rs2 behaves as a degenerative resistor for transconductance amplifier 45.

Although Rs1 and Rs2 also form a part of the overall active negative feedback network 47 of the two-stage direct amplifier, the feedback gain of the overall feedback network 47 may still be set arbitrarily without affecting the biasing condition of either first stage 43 or second stage 45. As explained above, this is because the gain of the overall feedback network 47 may be adjusted by changing the local feedback network belonging to Diff Amp 50 and including R_{F} and R_{E}. Since the local feedback network of Diff Amp 50 consists of a separate set of resistors R_{F} and R_{E}, they may be adjusted without affecting Rs1 or Rs2 and thereby not affect the two-stage direct amplifier.

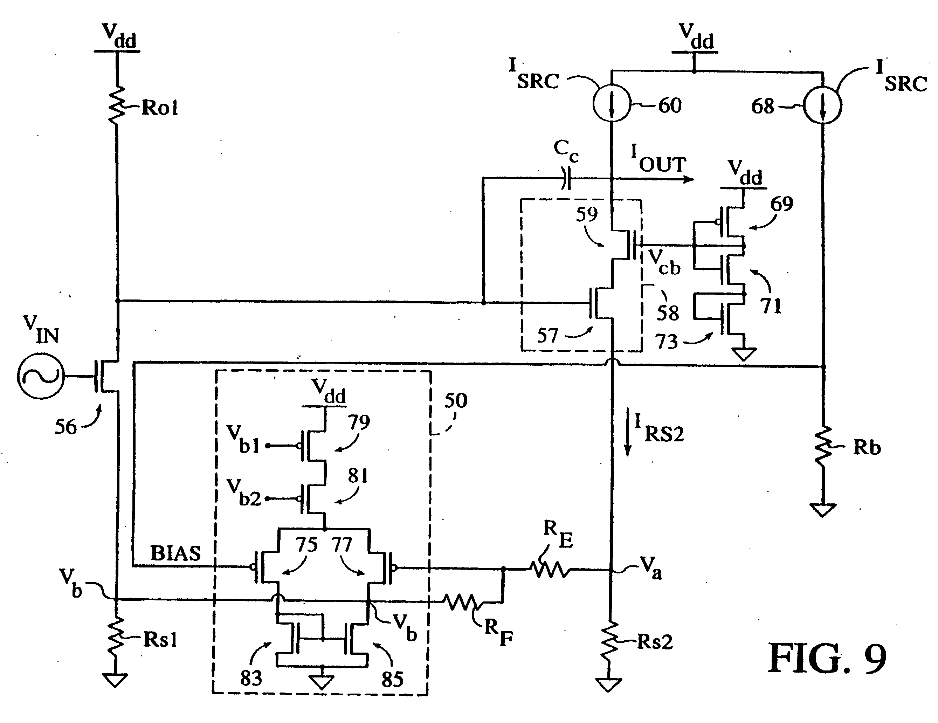

The voltage-to-current converter of the present invention may be optimized for a variety of criteria by proper selection of the first stage 43 and second stage 45 of the two-stage direct amplifier. In other words, there are various methods of implementing the voltage amplifier 43 of the first stage and the transconductance amplifier 45 of the second stage. Figs. 9 through 13 show by way of example some possible implementations. Those skilled in the art will recognize that there are additional methods of implementing the VI of the present invention, and the present invention is therefore not limited to the example circuits shown in Figs. 9 through 13.

A transistor level solution of the circuit of Fig. 8 is shown in Fig. 9. The voltage amplifier forming the first stage 43 of Fig. 8 is shown in Fig. 9 to consist of output, pull-up bias resistor Ro1, NMOS transistor 56 and regenerative feedback resistor Rs1. As is known in the art, this configuration of an inverting voltage amplifier has a high input impedance, low output impedance and a wide frequency response. The low output impedance of this inverting amplifier improves the linearity of the overall voltage-to-current converter of Fig. 9. Input signal V_{IN} is applied to the control gate of NMOS transistor 56 causing an inverted voltage output at the drain of NMOS transistor 56.

The inverted output of NMOS transistor 56 is applied to the control gate of NMOS transistor 57. NMOS transistor 57 is shown coupled to NMOS transistor 59 as a simple cascode 58 which forms the input stage to the transconductance amplifier of the second stage 45, as shown in Fig. 8. Cascode circuit 58 along with constant current source I_{SRC}, 60, and cascode bias voltage Vcb form a cascode transconductance gain stage which has the advantage of reducing the effective capacitance appearing at the input for high frequency operation, while at the same time providing a much higher output impedance and transconductance gain than available if a single transistor is used as the input stage. Cascode bias voltage Vcb is provided by a supply-independent CMOS bias circuit source consisting of transistors 69, 71, and 73. Additionally, to further improve its linearity and frequency response, a feedback capacitor Cc is coupled between the input of the transconductance amplifier at the gate of NMOS transistor 57 to the output of the transconductance amplifier at the drain of NMOS transistor 59.

The transconductance amplifier of Fig. 9 forming the second stage 45 of Fig. 8 is an inverting amplifier, but since it receives an inverted signal from the drain of transistor 56, the first stage of Fig. 9, the output current I_{OUT} is non-inverted and in phase with the input signal V_{IN}.

Current I_{OUT} consists of a DC component supplied by constant current source I_{SRC} 60 less an AC component introduced by AC variation at the control gate of NMOS transistor 57. A current I_{RS2} is I_{SRC} 60 less I_{OUT} and is therefore proportional to I_{OUT}. I_{RS2} leaves the cascode circuit 58 at the source of transistor 57 and passes through sensing resistor RS2, coupled between the source of NMOS transistor 57 and ground. Current I_{RS2} has a DC component proportional to the DC component of I_{OUT} and an AC component proportional to the inverse of the AC component of I_{OUT}. Thus, IRS2 is a gauge current indicating a measure of I_{OUT}. Therefore, as current I_{RS2} passes through sensing resistor Rs2, a voltage Va proportional to I_{OUT} is generated across Rs2. As explained above, the voltage va is applied through a resistor R_{E} to the inverting input of a Diff Amp 50 producing an amplified difference voltage at node Vb.

In Fig. 9, an exemplary transistor level solution of Diff Amp 50 is shown. Many transistor level implementations of Diff Amps are known. The selected transistor level implementation of Diff Amp 50 is not critical to the invention. Diff amp 50 has a cascode current source consisting of PMOS transistors 79 and 81 controlled by reference voltages Vb1 and Vb2, respectively. At the drain of PMOS transistor 81, the current path is divided into two differential paths controlled by PMOS transistors 75 and 77. The drains of transistors 75 and 77 are in turn coupled to ground through respective branches of a current mirror made up of NMOS transistors 83 and 85.

The gate of PMOS transistor 77 constitutes the inverting input of Diff Amp 50 and is coupled to input resistor R_{E}. Similarly, the drain of PMOS transistor 77 constitutes the output of Diff Amp 50 and is coupled through local feedback resistor R_{F} to the input at its gate.

The gate of PMOS transistor 75 constitutes the non-inverting input of Diff Amp 50 and is coupled to a reference bias voltage V_{BIAS}. As explained above, V_{BIAS} preferably has a value representative of the DC component of I_{OUT} such that Diff Amp 50 rejects the DC component of I_{OUT} and amplifies only the voltage representation of the AC component of I_{OUT}. In this case V_{BIAS} therefore preferably equals the DC component of the voltage at node Va.

To accomplish this, V_{BIAS} is tapped off a bias tree very similar to the transconductance amplifier, but which does not introduce any AC variations. V_{BIAS} is generated by a bias sensing resistor Rb, equal to sensing resistor Rs2, and receiving a bias DC current from a second constant current source I_{SRC} 68 equal to the constant current source I_{SRC} 60 of the cascode transconductance gain stage discussed above. This generates a voltage drop V_{BIAS} across bias resistor Rb equal to the DC component of the voltage at Va.

To finish the overall differential active feedback network 47 of Fig. 8, in Fig. 9 the output of Diff Amp 50 at node Vb is applied to the source of NMOS transistor 56 and degenerative resistor RS1 of the voltage amplifier, the first stage of the two-stage direct amplifier.

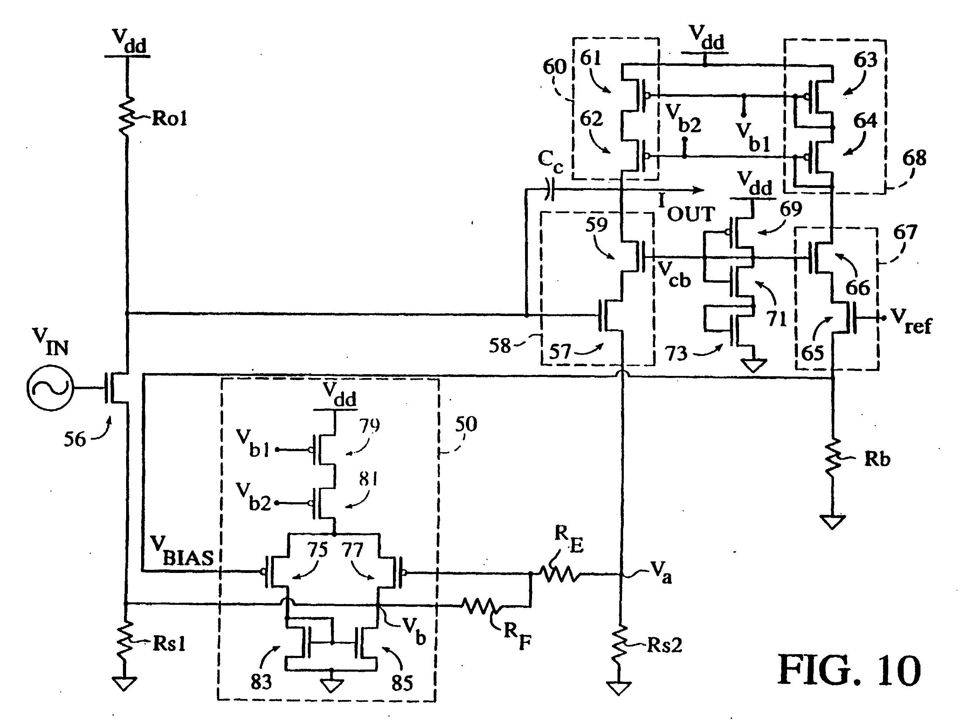

In Fig. 10, the V_{BIAS} generating branch and constant current sources 60 and 68 of Fig. 9 are further defined. Circuit components in Fig. 10 having similar functions and connections as in Fig. 9 are identified by reference characters similar to those of Fig. 9 and are explained above.

To ensure that constant current sources I_{SRC} 60 and 68 of Fig. 9 have similar current values, they are implemented as a current mirror in Fig. 10, more specifically a cascode current source. A cascode current source produces a low loading effect at its output. PMOS transistors 61 and 62 from a cascode current source 60 and generate I_{SRC} in response to a bias cascode current source 68 consisting of diode connected PMOS transistors 63 and 64. Because the control gates of matching transistor pairs 61/63 and 62/64 are coupled together, the current in bias cascode current source 68 is mirrored in cascode current source 60.

The current of the cascode current sources 60 and 68 are set by a third cascode circuit 67 consisting of NMOS transistors 66 and 65. Cascode circuit 67 is coupled along a single current path between bias cascode current source 68 and bias sensing resistor Rb. Thus, the current I_{SRC} in bias cascode current source 68, and thereby current in cascode current source 60, is determined by cascode circuit 67. NMOS transistor 66 is matched to NMOS transistor 59 and NMOS transistor 65 is matched to transistor 57. Further, NMOS transistor 66 shares the same reference cascode bias voltage Vcb as NMOS transistor 59. The bias DC current I_{SRC} of cascode current sources 60 and 68 are set by a DC reference voltage V_{ref} applied to the gate of input transistor 65. Thus, the bias tree consisting of cascode circuits 68 and 67 and resistor Rb has a structure identical to the structure of the transconductance amplifier consisting of cascode circuits 60 and 58 and resistor Rs2. In this way, the DC loading and voltage conditions at the inverting and non-inverting inputs of Diff Amp 50 are maintained similar through process, temperature and drift variations. Fig. 10 also shows that the bias voltages Vb1 and Vb2 controlling PMOS transistors 79 and 81 of Diff Amp 50 are generated at the control gate of PMOS transistors 63 and 64.

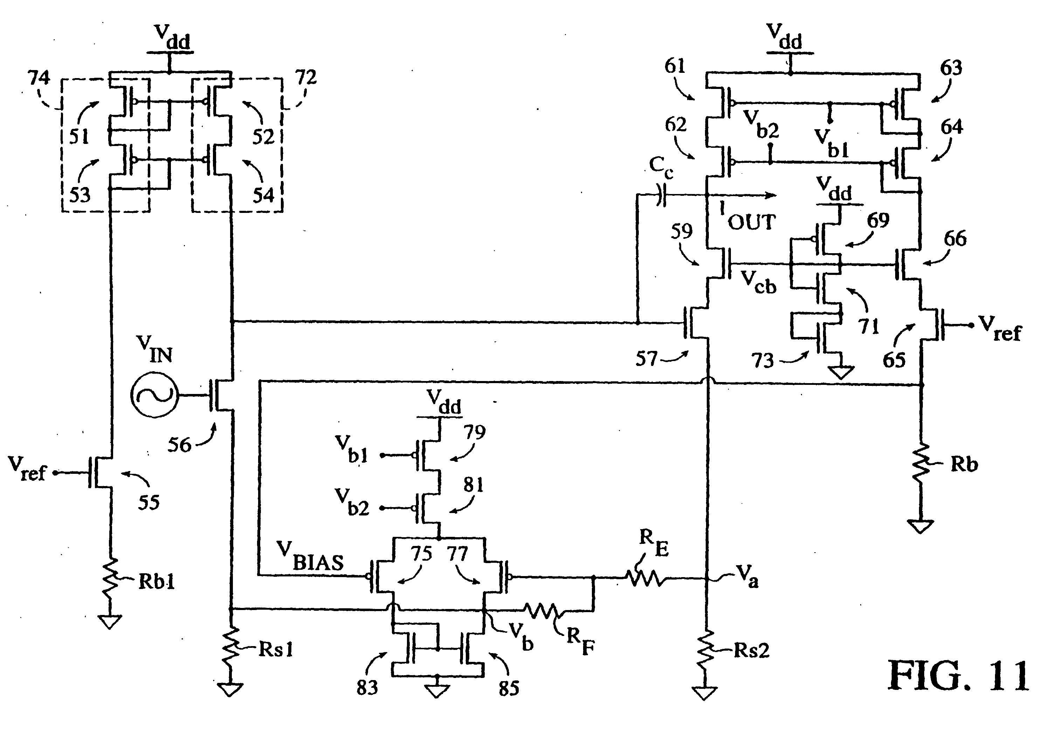

With reference to Fig. 11, a second embodiment of the present invention is shown. Circuit components in Fig. 11 having similar functions and connections as in Fig. 10 are identified by reference characters similar to those of Fig. 10 and are explained above. The output pull up resistor Ro1 of the voltage amplifier in Fig. 10 is replaced in Fig. 11 by a simple cascode current source 72 controlled by a second bias tree having a structure identical to the structure of the voltage amplifier itself. Use of a current source in the voltage amplifier, the first stage of the two-stage direct amplifier, results in a high output impedance for the overall voltage-to-current converter of Fig. 11, but also experiences reduced linearity, i.e. lower performance. The DC current from current source 72 is controlled by bias tree cascode current source 74 and is set by V_{ref} applied to the control gate of NMOS transistor 55 and by a second bias resistor Rb1. Transistors 52, 54 and 56 and resistor Rs1 match transistors 51, 53 and 55 and resistor Rb1, respectively. Transistor 56 is supplied by a DC current from cascode circuit 72 which mirrors the DC current in cascode circuit 74.

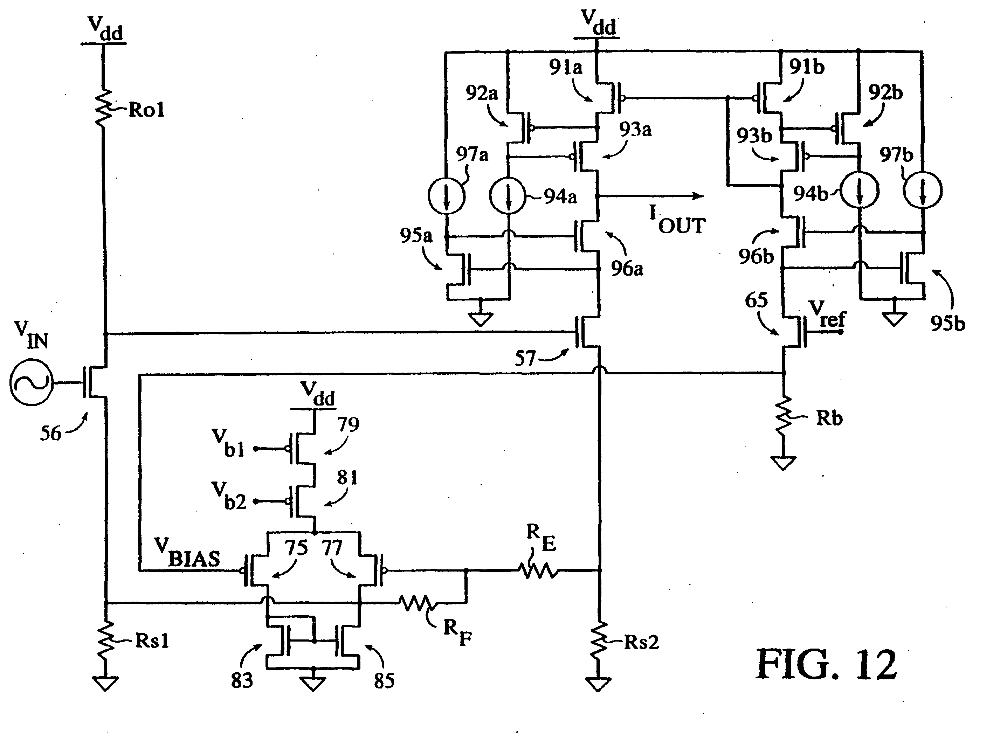

With reference to Fig. 12, a third embodiment of the present invention is shown. All components having similar functions and connections as in Fig. 10 are identified by reference characters similar to those of Fig. 10 and are explained above. In Fig. 12, an output pull up resistor Ro1 is once again used in the first, i.e. the voltage amplifier, stage of the two-stage direct amplifier. As explained above, this results in better linearity, but a lower output impedance. To improve the output impedance of the overall voltage-to-current converter of Fig. 12, a regulated cascode transconductance amplifier is used in the second stage, i.e. the transconductance amplifier, of the two-stage direct amplifier.

The regulated cascode transconductance amplifier, 91a-97a, is not self-biased. Rather, like in the case of the simple cascode transconductance amplifiers of Figs. 10 and 11, the regulated cascode transconductance amplifier 91a-97a is biased by a bias tree 91b-97b having a structure identical the gain stage 91a-97a of the regulated cascode transconductance amplifier. The only difference being that in order for the gain stage 91a-97a to mirror the current in bias tree 91a-97b, the device which couples together the two branches of the regulated cascode transconductance amplifier, in this case PMOS transistor 91b, is necessarily diode connected. By using a bias tree having the same circuit structure as the gain stage, DC bias and temperature variations as well as process drifts may be effectively canceled out.

The regulated cascode transconductance amplifier of Fig. 12 provides a higher input impedance than the simple cascode transconductance amplifier of Fig. 10, and thereby compensates for the lower output impedance of the first stage of Fig. 12, i.e. the voltage amplifier. The regulated cascode transconductance amplifier further has a higher transconductance gain, higher output impedance and wider frequency range. Additionally, the regulated cascode transconductance amplifier has a larger voltage swing allowing a better adjustment to the voltage of a load.

Transistors 91a-93a and current source 94a form a regulated cascode current source of the gain stage 91a-97a which mirrors the current in the regulated cascode current source 91b-94b of the bias tree 91b-97b. The two regulated current sources 91a-94a and 91b-94b form a current mirror due to a common connection between the control gates of PMOS transistors 91a and 91b. Due to PMOS transistor 91b being diode connected, the DC current of the regulated cascode bias tree is established by a reference voltage V_{ref} applied to the control gate of NMOS transistor 65.

The input stage of both the gain stage 91a-97a and the bias tree 91b-97b also consist of a regulated cascode circuit. The regulated cascode input stage of the gain stage 91a-97a consists of NMOS transistors 57, 95a and 96a along with current source 97a. Current source 97a and NMOS transistor 95a together form an amplifier which in turn forms a feedback loop with NMOS transistor 96a used as a source follower. Thus voltage at the drain of NMOS transistor 57 is self-regulated resulting in the improved performance features of the cascode transconductance amplifier explained above. The input stage of the bias tree consists of NMOS transistors 65, 95b and 96b along with current source 97b, and function in much the way same as the input stage of the amplifier stage.

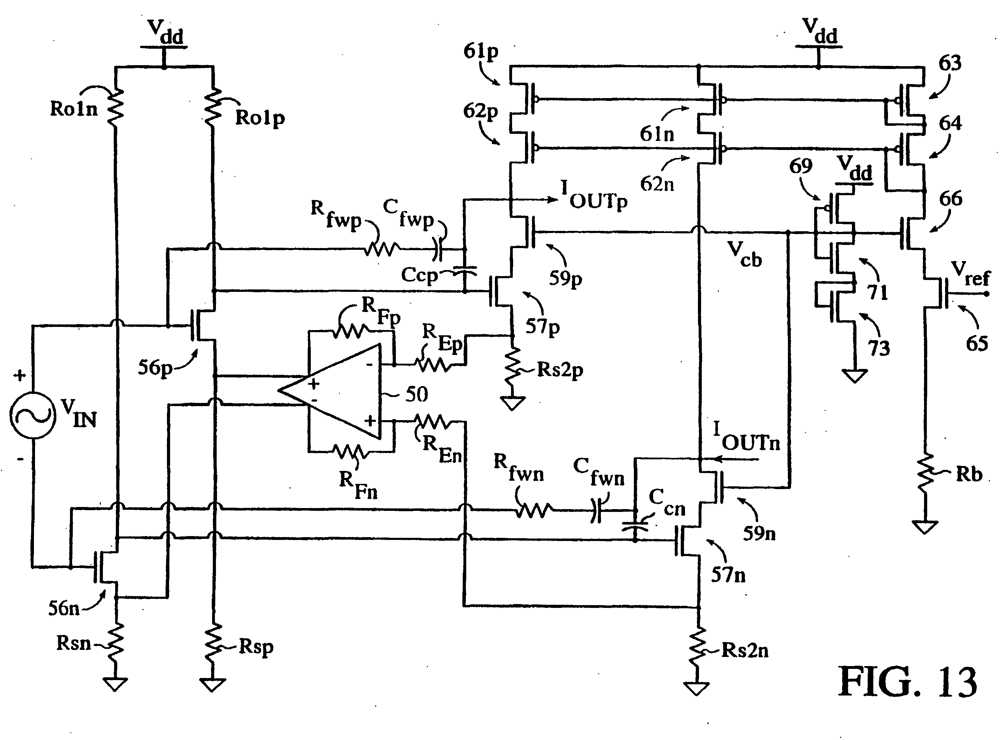

With reference with Fig. 13, a fully differential voltage-to-current converter in accord with the present invention is shown. The circuit of Fig. 13 functions substantially like the circuit of Fig. 10 except that instead of applying a bias voltage V_{BIAS} to the positive input of Diff Amp 50, the circuit Fig. 13 applies a second feedback input from a second voltage-to-current converter responsive to the negative node of the input signal V_{IN}. In other words, the circuit of Fig. 13 functions as two voltage-to-current converters sharing a common Diff Amp 50, a common cascode bias voltage Vcb generator 69-73, and a common bias tree 63-66. Again, the bias tree 63-66 has the same structure as the positive gain stage 57p-62p and negative gain stage 57n-62n.

One voltage-to-current converter is responsive to the positive output terminal of V_{IN} and is identified by a subscript "p" at the end of each reference character name and a second voltage-to-current converter is responsive to the negative output terminal of V_{IN} and is identified by a subscript "n" at the end of each reference character name. Circuit components in Fig. 13 having similar functions and connections as in Fig. 10 are identified by reference characters similar to those of Fig. 10 along with the appropriate subscript "p" or "n" and are explained above.

In order for both voltage-to-current converters of Fig. 13 to share a common Diff Amp 50, Diff Amp 50 is shown to have dual outputs. That is, it has a positive output and its complement, a negative output. The positive output of Diff Amp 50 is coupled to the first stage of the direct amplifier responsive to the positive output of V_{IN}. That is, the positive output of Diff Amp 50 is applied to the source of NMOS transistor 56p. Similarly, the negative output of Diff Amp 50 is coupled to the first stage of the direct amplifier is responsive to the negative output of V_{IN}, i.e. the source NMOS transistor 56n.

The frequency response of the circuit of Fig. 13 is further enhanced by the use of a series connected feedforward resistor Rfw and feedforward capacitor Cfw coupled between the input and output of the positive and negative voltage-to-current converters, respectively. For example, Rfwp and Cfwp are couple between the input of the positive responding first VI, i.e. the control gate of transistor 56p, and the output of the positive responding VI, i.e. the drain of transistor 59p. Similarly Rfwn and Cfwn are couple between the input of the negative responding second VI, i.e. the control gate of transistor 56n, and the output of the negative responding VI, i.e. the drain of transistor 59n. In this manner two output currents I_{OUT}p and I_{OUT}n are always available with I_{OUT}n being 180° out of phase with I_{OUT}p.

## Claims

1. A voltage-to-current converter with an active negative feedback network comprising:
a direct amplifier (42) having an input voltage node, a reference voltage node and an output node, said direct amplifier being effective for generating an output current (Iₒᵤₜ) on said output node, said output current being proportional to a voltage difference between said input voltage node and said reference voltage node, said output current having a DC output current component and an AC output current component, said direct amplifier further being effective for generating a gauge current proportional to said output current, said gauge current having a DC gauge component proportional to said DC output current component and having an AC gauge component proportional to said AC output current component;
means (40) for generating a DC bias signal (V_{bias}) proportional to said DC gauge component;
wherein said active negative feedback network consists of an active current-to-voltage converter (47) responsive to said output current and being effective for generating a feedback voltage signal (V_{b}) proportional to said AC output current component, said feedback voltage signal being coupled to said reference voltage node of said direct amplifier, said current-to-voltage converter further including a first differential input lead receiving said DC bias signal (V_{bias}), a second differential input lead receiving said gauge current, and an output feedback lead producing said feedback voltage signal, said current-to-voltage converter having local resistive feedback such that the gain of the active negative feedback network can be adjusted without affecting the biasing conditions of the direct amplifier.

2. The voltage-to-current converter of claim 1 wherein said current-to-voltage converter has a feedback gain magnitude other than unity and said feedback voltage signal is proportional only to said AC output current component.

3. The voltage-to-current converter of claim 1 wherein said DC bias signal is effective for cancelling said DC output current component.

4. The voltage-to-current converter of claim 1 wherein said current-to-voltage converter includes a differential amplifier having a local feedback network and having a local gain magnitude independent of said direct amplifier, said differential amplifier having an output lead coupled to said reference voltage node and having a third and fourth input lead responsive to said first and second differential input leads, respectively.

5. The voltage-to-current converter of claim 1 wherein said current-to-voltage converter includes a closed-loop voltage amplifier, a first sense resistor coupled between said output feedback lead and a reference ground rail and a second sense resistor coupled between said second differential input and said reference ground rail, said closed-loop voltage amplifier having a local output terminal coupled to said output feedback lead, having a first local input terminal responsive to said first differential input lead and having a second local input terminal responsive to said second differential input lead.

6. The voltage-to-current converter of claim 5 wherein said closed-loop voltage amplifier includes a local input resistor and a local feedback resistor, said closed-loop voltage amplifier having a gain magnitude proportional to the ratio of said local feedback resistor to said local input resistor.

7. The voltage-to-current converter of claim 1 wherein said current-to-voltage converter includes a means for sensing said gauge current, a differential amplifier, a local input resistor and a local feedback resistor, said differential amplifier including a positive input terminal, a negative input terminal and a local output terminal, said local input resistor being coupled between said negative input terminal and said means for sensing said gauge current, said local feedback resistor being coupled between said negative input terminal and said local output terminal, said local output terminal being coupled to said output feedback lead and said positive input terminal being coupled to said first differential input.

8. The voltage-to-current converter of claim 1 wherein said direct amplifier includes at least a first stage and a second stage, said first stage including a voltage-to-voltage converter coupled to said input voltage node and said reference voltage node, said voltage-to-voltage converter being effective for generating an intermediate voltage signal proportional to a voltage difference between said input voltage node and said reference voltage node, said second stage including a transconductance amplifier responsive to said intermediate voltage and being effective for generating said output current, said output current being proportional to said intermediate voltage signal.

9. The voltage-to-current converter of claim 8 wherein said first stage of said two-stage direct amplifier has feedback.

10. The voltage-to-current converter of claim 8 wherein said first stage additionally includes a bias source generating a control signal, said voltage-to-voltage converter having a current source, said current source being responsive to said control signal.

11. The voltage-to-current converter of claim 8 wherein said transconductance amplifier has an output node and a current source, said current source feeding into said output node.

12. The voltage-to-current converter of claim 11 wherein said current source is one of a unregulated cascode current source and a regulated cascode current source.

13. The voltage-to-current converter of claim 1 wherein said direct amplifier includes at least a first stage and a second stage;
said first stage including a voltage-to-voltage converter-including said input voltage node, said reference voltagte node and a first feedback resistor, said first feedback resistor being coupled between said reference voltage node and a reference ground rail, said voltage to-voltage converter being effective for generating an intermediate voltage proportional to a voltage difference between said input voltage node and said reference voltage node;
said second stage being responsive to said intermediate voltage and including a transconductance amplifier having a second reference voltage node, a second feedback resistor and said output node, said second feedback resistor being coupled between said second reference voltage node and said reference ground rail, said transconductance amplifier being effective for generating said output current on said output node, said output current being proportional to a voltage difference between said intermediate voltage and said second reference voltage node, said second feedback resistor generating a voltage sense signal having a DC sense component proportional to said DC output current component and an AC sense component proportional to said AC output current component; and
said current-to-voltage converter forming an active feedback network including:
(a) a differential amplifier having a first local input lead, a second local input lead and a local output lead, said local output lead being coupled to said reference voltage node of said voltage-to-voltage converter;
(b) said DC bias signal being coupled to said first local input lead;
(c) a local input resistor coupled between said second local input lead and said second reference node of said transconductance amplifier, and
(d) a local feedback resistor coupled between said second local input lead and said local output lead.

14. The voltage-to-current converter of claim 13 wherein said second stage further includes a bias source and said transconductance amplifier has an input stage and a current source, said input stage having a first current terminal coupled to said output node, a second current terminal coupled to said second reference voltage node and a control input responsive to said intermediate voltage, said control input being effect for varying an amount of current conduction between said first current terminal and said second current terminal, said current source being coupled to feed into said output node and further having a quiescent operating point establish by said bias source.

15. The voltage-to-current converter of claim 13 wherein said voltage-to-voltage converter includes a pull-up resistor and an MOS transistor having a control gate electrode coupled to said input voltage node, a source electrode coupled to said reference voltage node and a drain electrode generating said intermediate voltage, said pull-up resistor being coupled to said drain electrode.

16. The voltage-to-current converter of claim 13 wherein said first stage includes a bias source and said voltage-to-voltage converter includes an MOS transistor and a current source, said MOS transistor having a control gate electrode coupled to said input voltage node, a source electrode coupled to said reference voltage node and a drain electrode generating said intermediate voltage, said current source being coupled to feed into said drain electrode and further having a quiescent operating point establish by said bias source.

## Patentansprüche

1. Spannungs-Strom-Wandler mit einem aktiven Gegenkopplungsnetzwerk mit:
einem direkten Verstärker (42) mit einem Eingangsspannungsknoten, einem Bezugsspannungsknoten und einem Ausgangsknoten, wobei der direkte Verstärker zum Erzeugen eines Ausgangsstroms (Iₒᵤₜ) an dem Ausgangsknoten wirksam ist, wobei der Ausgangsstrom zu einer Spannungsdifferenz zwischen dem Eingangsspannungsknoten und dem Bezugsspannungsknoten proportional ist, wobei der Ausgangsstrom eine Ausgangsgleichstrom-Komponente und eine Ausgangswechselstrom-Komponente aufweist, wobei der direkte Verstärker ferner zum Erzeugen eines Messstroms wirksam ist, der zu dem Ausgangsstrom proportional ist, wobei der Messstrom eine Gleichstrom-Messkomponente aufweist, die zu der Ausgangsgleichstrom-Komponente proportional ist, und eine Wechselstrom-Messkomponente aufweist, die zu der Ausgangswechselstrom-Komponente proportional ist;
einem Mittel (40) zum Erzeugen eines Gleichstrom-Vorspannungssignals (V_{bias}), das zu der Gleichstrom-Messkomponente proportional ist;
wobei das aktive Gegenkopplungsnetzwerk aus einem aktiven Strom-Spannungs-Wandler (47) besteht, der auf den Ausgangsstrom reagiert und zum Erzeugen eines Rückführungsspannungssignals (V_{b}) wirksam ist, das zu der Ausgangswechselstrom-Komponente proportional ist, wobei das Rückführungsspannungssignal mit dem Bezugsspannungsknoten des direkten Verstärkers gekoppelt ist, wobei der Strom-Spannungs-Wandler ferner eine erste Differenzeingangs-Anschlussleitung, die das Gleichstrom-Vorspannungssignal (V_{bias}) empfängt, eine zweite Differenzeingangs-Anschlussleitung, die den Messstrom empfängt, und eine Ausgangsrückführungs-Anschlussleitung, die das Rückführungsspannungssignal erzeugt, umfasst, wobei der Strom-Spannungs-Wandler eine lokale Widerstandsrückführung aufweist, so dass die Verstärkung des aktiven Gegenkopplungsnetzwerks eingestellt werden kann, ohne die Vorspannungsbedingungen des direkten Verstärkers zu beeinflussen.

2. Spannungs-Strom-Wandler nach Anspruch 1, wobei der Strom-Spannungs-Wandler eine andere Rückführungsverstärkungsamplitude als Eins aufweist und das Rückführungsspannungssignal nur zu der Ausgangswechselstrom-Komponente proportional ist.

3. Spannungs-Strom-Wandler nach Anspruch 1, wobei das Gleichstrom-Vorspannungssignal zum Aufheben der Ausgangsgleichstrom-Komponente wirksam ist.

4. Spannungs-Strom-Wandler nach Anspruch 1, wobei der Strom-Spannungs-Wandler einen Differenzverstärker mit einem lokalen Rückführungsnetzwerk und mit einer lokalen Verstärkungsamplitude, die von dem direkten Verstärker unabhängig ist, umfasst, wobei der Differenzverstärker eine Ausgangsanschlussleitung aufweist, die mit dem Bezugsspannungsknoten gekoppelt ist, und eine dritte und eine vierte Eingangsanschlussleitung aufweist, die auf die erste bzw. die zweite Differenzeingangs-Anschlussleitung reagieren.

5. Spannungs-Strom-Wandler nach Anspruch 1, wobei der Strom-Spannungs-Wandler einen Spannungsverstärker in geschlossener Schleife, einen ersten Abtastwiderstand, der zwischen die Ausgangsrückführungs-Anschlussleitung und einen Bezugserdungs-Verbindungsbus gekoppelt ist, und einen zweiten Abtastwiderstand, der zwischen den zweiten Differenzeingang und den Bezugserdungs-Verbindungsbus gekoppelt ist, umfasst, wobei der Spannungsverstärker in geschlossener Schleife einen lokalen Ausgangsanschluss aufweist, der mit der Ausgangsrückführungs-Anschlussleitung gekoppelt ist, einen ersten lokalen Eingangsanschluss aufweist, der auf die erste Differenzeingangs-Anschlussleitung reagiert, und einen zweiten lokalen Eingangsanschluss aufweist, der auf die zweite Differenzeingangs-Anschlussleitung reagiert.

6. Spannungs-Strom-Wandler nach Anspruch 5, wobei der Spannungsverstärker in geschlossener Schleife einen lokalen Eingangswiderstand und einen lokalen Rückführungswiderstand umfasst, wobei der Spannungsverstärker in geschlossener Schleife eine Verstärkungsamplitude aufweist, die zum Verhältnis des lokalen Rückführungswiderstandes zum lokalen Eingangswiderstand proportional ist.

7. Spannungs-Strom-Wandler nach Anspruch 1, wobei der Strom-Spannungs-Wandler ein Mittel zum Abtasten des Messstroms, einen Differenzverstärker, einen lokalen Eingangswiderstand und einen lokalen Rückführungswiderstand umfasst, wobei der Differenzverstärker einen positiven Eingangsanschluss, einen negativen Eingangsanschluss und einen lokalen Ausgangsanschluss umfasst, wobei der lokale Eingangswiderstand zwischen den negativen Eingangsanschluss und das Mittel zum Abtasten des Messstroms gekoppelt ist, der lokale Rückführungswiderstand zwischen den negativen Eingangsanschluss und den lokalen Ausgangsanschluss gekoppelt ist, der lokale Ausgangsanschluss mit der Ausgangsrückführungs-Anschlussleitung gekoppelt ist und der positive Eingangsanschluss mit dem ersten Differenzeingang gekoppelt ist.

8. Spannungs-Strom-Wandler nach Anspruch 1, wobei der direkte Verstärker zumindest eine erste Stufe und eine zweite Stufe umfasst, wobei die erste Stufe einen Spannungs-Spannungs-Wandler umfasst, der mit dem Eingangsspannungsknoten und dem Bezugsspannungsknoten gekoppelt ist, wobei der Spannungs-Spannungs-Wandler zum Erzeugen eines Zwischenspannungssignals wirksam ist, das zu einer Spannungsdifferenz zwischen dem Eingangsspannungsknoten und dem Bezugsspannungsknoten proportional ist, wobei die zweite Stufe einen Steilheitsverstärker umfasst, der auf die Zwischenspannung reagiert und zum Erzeugen des Ausgangsstroms wirksam ist, wobei der Ausgangsstrom zum Zwischenspannungssignal proportional ist.

9. Spannungs-Strom-Wandler nach Anspruch 8, wobei die erste Stufe des direkten Zwei-Stufen-Verstärkers eine Rückführung aufweist.

10. Spannungs-Strom-Wandler nach Anspruch 8, wobei die erste Stufe außerdem eine Vorspannungsquelle umfasst, die ein Steuersignal erzeugt, wobei der Spannungs-Spannungs-Wandler eine Stromquelle aufweist, wobei die Stromquelle auf das Steuersignal reagiert.

11. Spannungs-Strom-Wandler nach Anspruch 8, wobei der Steilheitsverstärker einen Ausgangsknoten und eine Stromquelle aufweist, wobei die Stromquelle in den Ausgangsknoten speist.

12. Spannungs-Strom-Wandler nach Anspruch 11, wobei die Stromquelle eine von einer unregulierten Kaskodenstromquelle und einer regulierten Kaskodenstromquelle ist.

13. Spannungs-Strom-Wandler nach Anspruch 1, wobei der direkte Verstärker zumindest eine erste Stufe und eine zweite Stufe umfasst;
wobei die erste Stufe einen Spannungs-Spannungs-Wandler mit dem Eingangsspannungsknoten, dem Bezugsspannungsknoten und einem ersten Rückführungswiderstand umfasst, wobei der erste Rückführungswiderstand zwischen den Bezugsspannungsknoten und einen Bezugserdungs-Verbindungsbus gekoppelt ist, wobei der Spannungs-Spannungs-Wandler zum Erzeugen einer Zwischenspannung, die zu einer Spannungsdifferenz zwischen dem Eingangsspannungsknoten und dem Bezugsspannungsknoten proportional ist, wirksam ist;
wobei die zweite Stufe auf die Zwischenspannung reagiert und einen Steilheitsverstärker mit einem zweiten Bezugsspannungsknoten, einem zweiten Rückführungswiderstand und dem Ausgangsknoten umfasst, wobei der zweite Rückführungswiderstand zwischen den zweiten Bezugsspannungsknoten und den Bezugserdungs-Verbindungsbus gekoppelt ist, wobei der Steilheitsverstärker zum Erzeugen des Ausgangsstroms an dem Ausgangsknoten wirksam ist, wobei der Ausgangsstrom zu einer Spannungsdifferenz zwischen der Zwischenspannung und dem zweiten Bezugsspannungsknoten proportional ist, wobei der zweite Rückführungswiderstand ein Spannungsabtastsignal mit einer Gleichstrom-Abtastkomponente, die zu der Ausgangsgleichstrom-Komponente proportional ist, und einer Wechselstrom-Abtastkomponente, die zu der Ausgangswechselstrom-Komponente proportional ist, erzeugt; und
wobei der Strom-Spannungs-Wandler ein aktives Rückführungsnetzwerk bildet, mit:
(a) einem Differenzverstärker mit einer ersten lokalen Eingangsanschlussleitung, einer zweiten lokalen Eingangsanschlussleitung und einer lokalen Ausgangsanschlussleitung, wobei die lokale Ausgangsanschlussleitung mit dem Bezugsspannungsknoten des Spannungs-Spannungs-Wandlers gekoppelt ist;
(b) wobei das Gleichstrom-Vorspannungssignal mit der ersten lokalen Eingangsanschlussleitung gekoppelt ist;
(c) einem lokalen Eingangswiderstand, der zwischen die zweite lokale Eingangsanschlussleitung und den zweiten Bezugsknoten des Steilheitsverstärkers gekoppelt ist, und
(d) einem lokalen Rückführungswiderstand, der zwischen die zweite lokale Eingangsanschlussleitung und die lokale Ausgangsanschlussleitung gekoppelt ist.

14. Spannungs-Strom-Wandler nach Anspruch 13, wobei die zweite Stufe ferner eine Vorspannungsquelle umfasst und der Steilheitsverstärker eine Eingangsstufe und eine Stromquelle aufweist, wobei die Eingangsstufe einen ersten Stromanschluss, der mit dem Ausgangsknoten gekoppelt ist, einen zweiten Stromanschluss, der mit dem zweiten Bezugsspannungsknoten gekoppelt ist, und einen Steuereingang, der auf die Zwischenspannung reagiert, aufweist, wobei der Steuereingang zum Verändern eines Ausmaßes an Stromleitung zwischen dem ersten Stromanschluss und dem zweiten Stromanschluss wirksam ist, wobei die Stromquelle zum Speisen in den Ausgangsknoten gekoppelt ist und ferner einen statischen Arbeitspunkt aufweist, der durch die Vorspannungsquelle festgelegt wird.

15. Spannungs-Strom-Wandler nach Anspruch 13, wobei der Spannungs-Spannungs-Wandler einen Pull-up-Widerstand und einen MOS-Transistor mit einer Steuergateelektrode, die mit dem Eingangsspannungsknoten gekoppelt ist, einer Sourceelektrode, die mit dem Bezugsspannungsknoten gekoppelt ist, und einer Drainelektrode, die die Zwischenspannung erzeugt, umfasst, wobei der Pull-up-Widerstand mit der Drainelektrode gekoppelt ist.

16. Spannungs-Strom-Wandler nach Anspruch 13, wobei die erste Stufe eine Vorspannungsquelle umfasst und der Spannungs-Spannungs-Wandler einen MOS-Transistor und eine Stromquelle umfasst, wobei der MOS-Transistor eine Steuergateelektrode, die mit dem Eingangsspannungsknoten gekoppelt ist, eine Sourceelektrode, die mit dem Bezugsspannungsknoten gekoppelt ist, und eine Drainelektrode, die die Zwischenspannung erzeugt, umfasst, wobei die Stromquelle zum Speisen in die Drainelektrode gekoppelt ist und ferner einen statischen Arbeitspunkt aufweist, der durch die Vorspannungsquelle festgelegt wird.

## Revendications

1. Convertisseur tension-courant avec un réseau actif de contre-réaction négative comprenant :
un amplificateur direct (42) ayant un noeud de tension d'entrée, un noeud de tension de référence et un noeud de sortie, ledit amplificateur direct agissant pour générer un courant de sortie (Iₒᵤₜ) sur ledit noeud de sortie, ledit courant de sortie étant proportionnel à une différence de tension entre ledit noeud de tension d'entrée et ledit noeud de tension de référence, ledit courant de sortie comportant une composante de courant de sortie en courant continu et une composante de courant de sortie en courant alternatif, ledit amplificateur direct agissant en outre pour générer un courant de mesure proportionnel audit courant de sortie, ledit courant de mesure comportant une composante de mesure en courant continu proportionnelle à ladite composante de courant de sortie en courant continu, et comportant une composante de mesure en courant alternatif proportionnelle à ladite composante de courant de sortie en courant alternatif,
un moyen (40) destiné à générer un signal de polarisation en courant continu (V_{bias}) proportionnel à ladite composante de mesure en courant continu, dans lequel ledit réseau actif de contre-réaction négative consiste en un convertisseur courant-tension actif (47) sensible audit courant de sortie et agissant pour générer un signal de tension de contre-réaction (V_{b}) proportionnel à ladite composante de courant de sortie en courant alternatif, ledit signal de tension de contre-réaction étant relié audit noeud de tension de référence dudit amplificateur direct, ledit convertisseur courant-tension comprenant en outre un premier conducteur d'entrée différentielle recevant ledit signal de polarisation en courant continu (V_{bias}), un second conducteur d'entrée différentielle recevant ledit courant de mesure, et un conducteur de contre-réaction de sortie produisant ledit signal de tension de contre-réaction, ledit convertisseur courant-tension ayant une contre-réaction résistive locale de sorte que le gain du réseau de contre-réaction actif peut être ajusté sans affecter les conditions de polarisation de l'amplificateur direct.

2. Convertisseur tension-courant selon la revendication 1, dans lequel ledit convertisseur courant-tension présente une amplitude de gain de contre-réaction autre que l'unité et ledit signal de tension de contre-réaction est proportionnel uniquement à ladite composante de courant de sortie en courant alternatif.

3. Convertisseur tension-courant selon la revendication 1, dans lequel ledit signal de polarisation en courant continu agit pour annuler ladite composante de courant de sortie en courant continu.

4. Convertisseur tension-courant selon la revendication 1, dans lequel ledit convertisseur courant-tension comprend un amplificateur différentiel comportant un réseau de contre-réaction local, et présentant une amplitude de gain local indépendante dudit amplificateur direct, ledit amplificateur différentiel ayant un conducteur de sortie relié audit noeud de tension de référence et ayant un troisième et un quatrième conducteurs d'entrée sensibles respectivement auxdits premier et second conducteurs de l'entrée différentielle.

5. Convertisseur tension-courant selon la revendication 1, dans lequel ledit convertisseur courant-tension comprend un amplificateur de tension en boucle fermée, une première résistance de détection reliée entre ledit conducteur de contre-réaction de sortie et une ligne de masse de référence, et une seconde résistance de détection reliée entre ladite seconde entrée différentielle et ladite ligne de masse de référence, ledit amplificateur de tension en boucle fermée ayant une borne de sortie locale reliée audit conducteur de contre-réaction de sortie, ayant une première borne d'entrée locale sensible audit premier conducteur d'entrée différentielle, et ayant une seconde borne d'entrée locale sensible audit second conducteur d'entrée différentielle.

6. Convertisseur tension-courant selon la revendication 5, dans lequel ledit amplificateur de tension à boucle fermée comprend une résistance d'entrée locale et une résistance de contre-réaction locale, ledit amplificateur de tension en boucle fermée présentant une amplitude de gain proportionnelle au rapport de ladite résistance de contre-réaction locale et de ladite résistance d'entrée locale.

7. Convertisseur tension-courant selon la revendication 1, dans lequel ledit convertisseur courant-tension comprend un moyen destiné à détecter ledit courant de mesure, un amplificateur différentiel, une résistance d'entrée locale et une résistance de contre-réaction locale, ledit amplificateur différentiel comprenant une borne d'entrée positive, une borne d'entrée négative et une borne de sortie locale, ladite résistance d'entrée locale étant reliée entre ladite borne d'entrée négative et ledit moyen destiné à détecter ledit courant de mesure, ladite résistance de contre-réaction locale étant reliée entre ladite borne d'entrée négative et ladite borne de sortie locale, ladite borne de sortie locale étant reliée audit conducteur de contre-réaction de sortie et ladite borne d'entrée positive étant reliée à ladite première entrée différentielle.

8. Convertisseur tension-courant selon la revendication 1, dans lequel ledit amplificateur direct comprend au moins un premier étage et un second étage, ledit premier étage comprenant un convertisseur tension-tension relié audit noeud de tension d'entrée et audit noeud de tension de référence, ledit convertisseur tension-tension agissant pour générer un signal de tension intermédiaire proportionnel à une différence de tension entre ledit noeud de tension d'entrée et ledit noeud de tension de référence, ledit second étage comprenant un amplificateur à transconductance sensible à ladite tension intermédiaire, et agissant pour générer ledit courant de sortie, ledit courant de sortie étant proportionnel audit signal de tension intermédiaire.

9. Convertisseur tension-courant selon la revendication 8, dans lequel ledit premier étage dudit amplificateur direct à deux étages comporte une contre-réaction.

10. Convertisseur tension-courant selon la revendication 8, dans lequel ledit premier étage comprend en plus une source de polarisation générant un signal de commande, ledit convertisseur tension-tension ayant une source de courant, ladite source de courant étant sensible audit signal de commande.

11. Convertisseur tension-courant selon la revendication 8, dans lequel ledit amplificateur à transconductance comporte un noeud de sortie et une source de courant, ladite source de courant chargeant ledit noeud de sortie.

12. Convertisseur tension-courant selon la revendication 11, dans lequel ladite source de courant est l'une d'une source de courant cascode non régulée et d'une source de courant cascode régulée.

13. Convertisseur tension-courant selon la revendication 1, dans lequel ledit amplificateur direct comprend au moins un premier étage et un second étage,
ledit premier étage comprenant un convertisseur tension-tension comprenant ledit noeud de tension d'entrée, ledit noeud de tension de référence et une première résistance de contre-réaction, ladite première résistance de contre-réaction étant reliée entre ledit noeud de tension de référence et une ligne de masse de référence, ledit convertisseur tension-tension agissant pour générer une tension intermédiaire proportionnelle à une différence de tension entre ledit noeud de tension d'entrée et ledit noeud de tension de référence,
ledit second étage étant sensible à ladite tension intermédiaire, et comprenant un amplificateur à transconductance comportant un second noeud de tension de référence, une seconde résistance de contre-réaction et ledit noeud de sortie, ladite seconde résistance de contre-réaction étant reliée entre ledit second noeud de tension de référence et ladite ligne de masse de référence, ledit amplificateur à transconductance agissant pour générer ledit courant de sortie sur ledit noeud de sortie, ledit courant de sortie étant proportionnel à une différence de tension entre ladite tension intermédiaire et ledit second noeud de tension de référence, ladite seconde résistance de contre-réaction générant un signal de détection de tension ayant une composante de détection en courant continu proportionnelle à ladite composante de courant de sortie en courant continu, et une composante de détection en courant alternatif proportionnelle à ladite composante de courant de sortie en courant alternatif, et
ledit convertisseur courant-tension formant un réseau de contre-réaction actif comprenant :
(a) un amplificateur différentiel ayant un premier conducteur d'entrée local, un second conducteur d'entrée local et un conducteur de sortie local, ledit conducteur de sortie local étant relié audit noeud de tension de référence dudit convertisseur tension-tension,
(b) ledit signal de polarisation en courant continu étant relié audit premier conducteur d'entrée local,
(c) une résistance d'entrée locale reliée entre ledit second conducteur d'entrée local et ledit second noeud de référence dudit amplificateur à transconductance, et
(d) une résistance de contre-réaction locale reliée entre ledit second conducteur d'entrée local et ledit conducteur de sortie local.

14. Convertisseur tension-courant selon la revendication 13, dans lequel ledit second étage comprend en outre une source de polarisation, et ledit amplificateur à transconductance comporte un étage d'entrée et une source de courant, ledit étage d'entrée comportant une première borne de courant reliée audit noeud de sortie, une seconde borne de courant reliée audit second noeud de tension de référence et une entrée de commande sensible à ladite tension intermédiaire, ladite entrée de commande étant employée pour modifier une valeur de conduction de courant entre ladite première borne de courant et ladite seconde borne de courant, ladite source de courant étant reliée pour charger ledit noeud de sortie et présentant en outre un point de fonctionnement au repos déterminé par ladite source de polarisation.

15. Convertisseur tension-courant selon la revendication 13, dans lequel ledit convertisseur tension-tension comprend une résistance d'excursion haute et un transistor de type MOS ayant une électrode de grille de commande reliée audit noeud de tension d'entrée, une électrode de source reliée audit noeud de tension de référence et une électrode de drain générant ladite tension intermédiaire, ladite résistance d'excursion haute étant reliée à ladite électrode de drain.

16. Convertisseur tension-courant selon la revendication 13, dans lequel ledit premier étage comprend une source de polarisation, et ledit convertisseur tension-tension comprend un transistor de type MOS et une source de courant, ledit transistor MOS ayant une électrode de grille de commande reliée audit noeud de tension d'entrée, une électrode de source reliée audit noeud de tension de référence et une électrode de drain générant ladite tension intermédiaire, ladite source de courant étant reliée pour charger ladite électrode de drain et ayant en outre un point de fonctionnement au repos déterminé par ladite source de polarisation.
